Europäisches Patentamt

(19) European Patent Office  (11) Numéro de publication: **0 005 160**

Office européen des brevets  **B1**

(12)  **FASCICULE DE BREVET EUROPEEN**

(45) Date de publication du fascicule de brevet: **12.08.81**  (51) Int. Cl.³: **H 01 L 31/10**

(21) Numéro de dépôt: **79100818.8**

(22) Date de dépôt: **16.03.79**

(54) **Photodiode PIN.**

(30) Priorité: **17.04.78 US 896872**

(43) Date de publication de la demande:
**14.11.79 Bulletin 79/23**

(45) Mention de la délivrance du brevet:
**12.08.81 Bulletin 81/32**

(84) Etats Contractants Désignés:
**DE FR GB**

(56) Documents cités:
**US - A - 3 324 297**
**US - A - 3 385 981**
**US - A - 3 840 741**
**US - A - 3 896 305**

(73) Titulaire: **International Business Machines Corporation**
**Armonk, N.Y. 10504 (US)**

(72) Inventeur: **Burke, Richard, Gary**
**3101 Cartwright Drive**
**Raleigh NC 27612 (US)**
Inventeur: **Kolodzey, James, Stanley**
**Route 4 Box 547**
**Chapel Hill NC 27514 (US)**

(74) Mandataire: **Bonin, Jean-Jacques**
**COMPAGNIE IBM FRANCE Département de Propriété Industrielle**
**F-06610 La Gaude (FR)**

Courier Press, Leamington Spa, England.

Photodiode PIN

Domaine technique

La présente invention concerne les détecteurs lumineux à photodiodes et plus particulièrement, un nouveau détecteur lumineux à photodiodes PIN à entrée latérale et une construction nouvelle permettant une amélioration substantielle des performances.

Technique antérieure

Les communications par fibre optique utilisent généralement une source lumineuse modulée telle qu'une diode électroluminescente (LED), un détecteur lumineux à photodiode (PD) et une fibre de verre ou de plastique interconnectant la diode LED et la photodiode PD. Dans la plupart des cas, la diode LED est modulée par un signal numérique à deux niveaux et émet l'une des deux intensités lumineuses dépendant du signal numérique qui est appliqué à la diode LED. La photodiode PD répond à l'intensité lumineuse conduite par la fibre et délivre une sortie sous la forme d'un signal électrique correspondant à ladite intensité, reproduisant ainsi sous une forme électrique utilisable, l'information modulée sur la diode LED à une certaine distance.

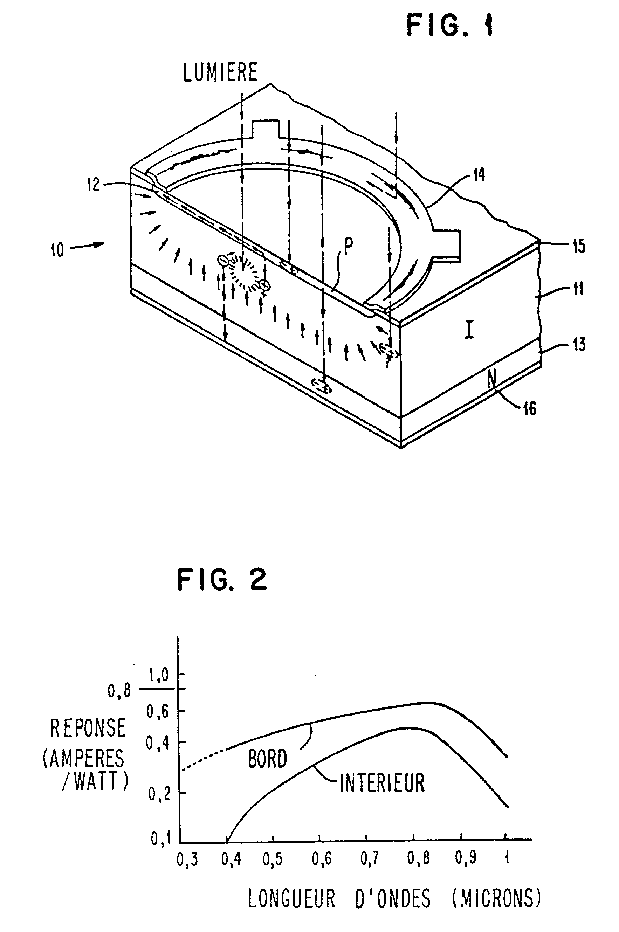

Diverses photodiodes PN et PIN sont maintenant disponibles. Aucune des structures de l'art antérieur n'est complètement satisfaisante étant donné qu'aucune d'entre elles ne peut être facilement intégrée avec le circuit récepteur dans une microplaquette monolithique à deux dimensions. Une photodiode PIN courante et connue dans l'art antérieur, est représentée à la figure 1. Cet agencement plat, outre les difficultés rencontrées pour son intégration, présente d'autres limitations et inconvénients substantiels.

La photodiode PIN de la figure 1 est construite sur une microplaquette de silicium 10 qui présente une région I 11, une région mince P 12 et une région N 13. Une anode 14 en forme d'anneau est en contact avec la région mince P 12 et avec une couche d'oxyde de silicium 15. Une cathode en aluminium 16 est déposée sur la surface plane de la région N 13.

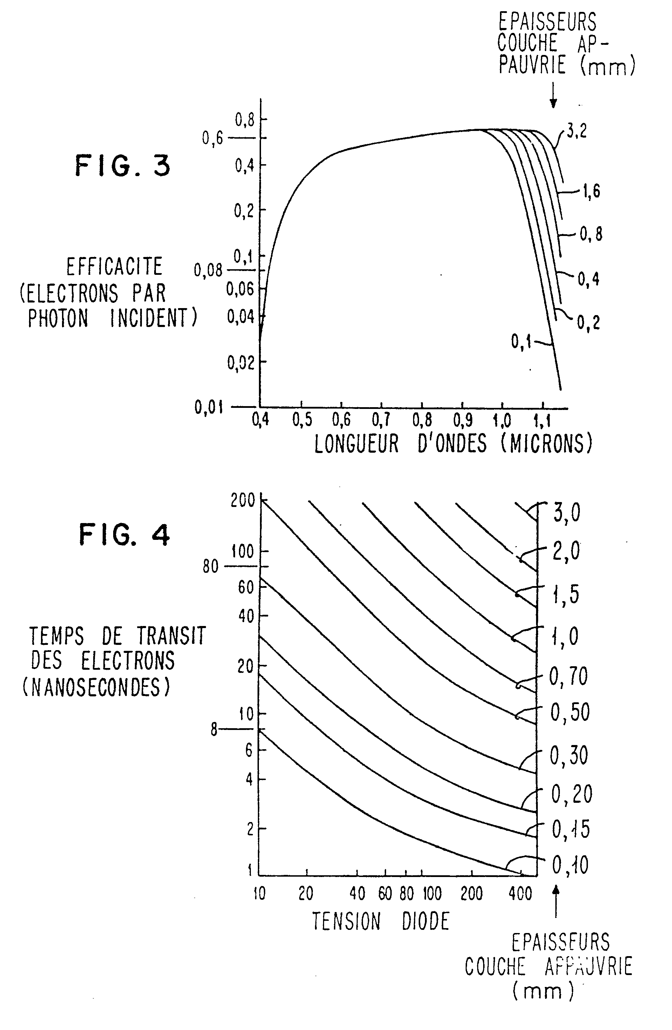

La lumière incidente, par exemple, la lumière sortant d'une fibre de transmission, passe au travers de la région mince P et est détectée par absorption dans la région I. Cependant, une certaine quantité de lumière traverse cette région, en particulier aux longueurs d'onde les plus longues en raison de l'épaisseur limitée de la région I dans la direction verticale comme on le voit dans la figure. Cette dimension doit être limitée afin de maintenir une vitesse acceptable. En effet si on accroît cette dimension, on améliore la réponse, mais par contre les porteurs générés doivent parcourir des distances plus longues et le temps de transit s'accroît (voir la figure 4 qui montre l'effet de la variation de l'épaisseur de la région I sur le temps de transit). La courbe de réponse représentée à la figure 2 montre une chute de la réponse au-dessous de 0,8 microns, provoquée par la dimension verticale limitée de la région I. Le graphique de la figure 3 représente l'efficacité en fonction de l'épaisseur de la région I et de la longueur d'onde, montrant encore graphiquement les contraintes affectant le fonctionnement de la structure de la figure 1.

Outre les compromis indiqués ci-dessus concernant l'épaisseur de la région I, la faible épaisseur de la région P requise pour transférer l'énergie lumineuse est électriquement indésirable étant donné que sa minceur augmente la résistivité du dispositif.

On connaît aussi des photodiodes de type PIN, notamment dans les brevets US—A—3 324 297 et US—A—3 385 981, dans lesquelles la lumière incidente est appliquée latéralement par rapport à la direction longitudinale définie pour les couches successives P, I et N. Cependant dans tous les dispositifs connus de ce type on prévoit une couche I de dimension longitudinale importante pour augmenter la surface d'impact des radiations lumineuses incidentes, et on obtient les faibles temps de transit désirés en appliquant au dispositif des tensions élevées. Ces diverses caractéristiques interdisent pratiquement la réalisation de tels dispositifs sous forme de circuits intégrés.

Brève description de l'invention

La présente invention envisage l'utilisation d'une nouvelle photodiode PIN formée d'une microplaquette semi-conductrice présentant une région P plane et épaisse séparée d'une région N plane par une région I plane et mince, comportant des moyens assurant l'admission directe de l'énergie lumineuse à la région I dans une direction parallèle à l'orientation plane de la région I et des moyens électriquement conducteurs en contact avec les régions P et N pour assurer la connexion de la photodiode PIN aux circuits électroniques formés sur ladite microplaquette semi-conductrice ou sur tout autre élément similaire.

L'épaisseur de la région I est sensiblement inférieure à celles des régions P et N, mais sa dimension dans la direction des rayons lumineux est suffisamment grande pour absorber la plus forte longueur d'onde lumineuse désirée.

D'autres objets, caractéristiques et avantages de la présente invention ressortiront mieux de l'exposé qui suit, fait en référence aux dessins annexés à ce texte, qui représentent un mode de réalisation préféré de celle-ci.

Brève description des dessins

La figure 1 est une représentation schématique d'une photodiode PIN de l'art antérieur.

Les figures 2, 3 et 4 sont des représentations graphiques illustrant les caractéristiques de fonctionnement du dispositif représenté à la figure 1.

La figure 5 est une représentation schématique d'une photodiode PIN réalisée selon les enseignements de la présente invention.

La figure 6 est une représentation schématique d'une photodiode PIN réalisée selon les enseignements de la présente invention et des circuits électroniques associés réalisés sur la même microplaquette semi-conductrice.

La figure 7 est une représentation schématique du circuit électrique du dispositif représenté à la figure 6.

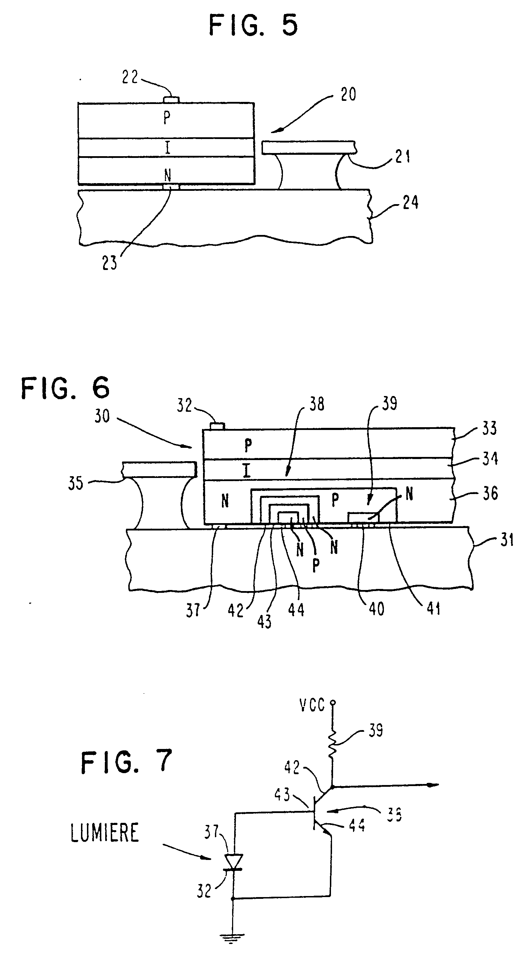

Dans la figure 5, on voit une microplaquette semiconductrice 20 comportant des régions planes P et N et une région intrinsèque I relativement mince. Les régions P et N peuvent être aussi épaisses que l'on souhaite étant donné qu'aucune énergie lumineuse ne les traverse. La région I peut être tout à fait mince dans la direction verticale étant donné que la lumière issue de la fibre de verre 21 la pénètre dans la direction de son plan. Cette dimension peut être aussi grande que nécessaire pour obtenir la réponse désirée sans affecter la vitesse du dispositif étant donné que les porteurs formés par absorption se déplacement dans la direction perpendiculaire au plan, et que leur déplacement n'est donc pas affecté par un accroissement de dimension de la région I dans la direction du plan. Des électrodes 22 et 23 sont déposées sur les régions P et N pour assurer la connexion avec des circuits électroniques qui peuvent être formés sur la même microplaquette (p. ex. en silicium) comme représente à la figure 6. L'entière structure peut être portée par un substrat approprié 24.

Dans la figure 6, on voit une microplaquette semiconductrice 30 disposée sur un substrat 31 et comprenant une photodiode PIN formée à l'intérieur de celle-ci. La diode comprend une anode 32 déposée sur une région P épaisse 33, une région I mince 34 qui reçoit l'énergie lumineuse issue d'une fibre optique 35 qui est collée au substrat 31 et une région N plus épaisse 36 qui comporte une cathode 37 déposée sur celle-ci.

Comme exemple de circuit supplémentaire, on voit que la microplaquette 30 comprend un transistor NPN 38 et une résistance 39 formée par une région N 40 dans une région P 41. Le transistor 38 comprend un collecteur diffusé N 42, une base diffusée P 43 et un émetteur diffusé N 44 interconnecté comme représenté dans la figure 7. On notera que des procédés autres que les procédés de diffusion peuvent être utilisés pour fabriquer la structure décrite ci-dessus.

La représentation schématique du circuit électrique de la figure 7 est identique au circuit formé sur la microplaquette 30 de la figure 6 et ledit circuit est présenté ici afin d'illustrer plus clairement le fonctionnement des circuits fabriqués sur la microplaquette 30 de la figure 6. La résistance 39 est connectée à une alimentation VCC et l'émetteur est connecté à la masse. L'anode 37 de la diode PIN est connectée à la base 43 du transistor 38 et la cathode 32 est raccordée à la masse. Le transistor 38 amplifie le signal délivré par la photodiode PIN. D'une manière similaire, des circuits supplémentaires peuvent être ajoutés à la microplaquette 30 selon les besoins.

Bien que l'on ait décrit dans ce qui précède et représenté sur les dessins les caractéristiques essentielles de l'invention appliquées à un mode de réalisation préféré de celle-ci, il est évident que l'homme de l'art peut y apporter toutes modifications de forme ou de détail qu'il juge utiles, sans pour autant sortir du cadre de ladite invention.

**Revendications**

1. Photodiode PIN, du genre comprenant: une région semi-conductrice dopée de type P, une région semi-conductrice dopée de type N, une région semi-conductrice intrinsèque I, disposée entre lesdites régions P et N et adjacente à ces dernières dont la dimension transversale, c'est-à-dire normale à la direction longitudinale définie par les régions successives P, I et N, est suffisante pour produire une réponse élevée pour une large gamme de longueurs d'onde d'énergie lumineuse appliquée dans le sens de ladite dimension, une électrode d'anode (22) en contact avec ladite région P et une électrode de cathode (23) en contact avec ladite région N, caractérisée en ce que l'épaisseur de ladite région I dans la direction longitudinale est sensiblement inférieure à celle desdites régions P et N et ladite dimension transversale est suffisamment grande pour absorber la plus forte longueur d'onde lumineuse désirée.

2. Photodiode PIN selon la revendication 1 caractérisée en ce que des moyens sont prévus pour admettre l'energie lumineuse d'excitation directement au droit de ladite région I, dans la direction transversale.

3. Photodiode PIN selon la revendication 2, caractérisée en ce que lesdits moyens pour admettre l'énergie lumineuse sont constitués par au moins une fibre optique (21, 35) raccordée à une source d'énergie lumineuse.

4. Photodiode PIN selon l'une quelconque des revendications précédentes, caractérisée en ce que: lesdites régions P, I et N sont formées dans une même microplaquette semi-conductrice (20, 30) et ladite microplaquette (20, 30) est montée sur un substrat (24, 31).

5. Photodiode PIN selon l'une quelconque des revendications précédentes, caractérisée en ce que ladite microplaquette (20, 30) est en silicium.

## Claims

1. A PIN photo-diode comprising:
a doped semiconductor of the P type,
a doped semiconductor region of the N type,
an intrinsic semiconductor I region, disposed between and adjacent to said P and N regions, whose transversal dimension, that is the one extending in the direction perpendicular to the longitudinal direction defined by the successive P, I and N regions, is sufficient for producing a high response for a wide range of photo-energy wave lengths applied along said dimension, an anode electrode (22) in contact with said P region, and a cathode electrode (23) in contact with said N region, characterized in that the thickness of said I region in the longitudinal direction is substantially smaller than that of said P and N regions, and said transversal dimension is sufficiently large for absorbing the longest light wave length desired.

2. A PIN photo-diode according to claim 1, characterized in that means are provided for admitting the controlling photo-energy directly in front of said I region in the transversal direction.

3. A PIN photo-diode according to claim 2, characterized in that said means for admitting the photo-energy consist of at least one optical fiber (21, 35) connected to a photo-energy source.

4. A PIN photo-diode according to any one of the preceding claims, characterized in that: said P, I and N regions are formed in the same semiconductor chip (20, 30) and said semiconductor chip (20, 30) is supported by a substrate (24, 31).

5. A PIN photo-diode according to any one of the preceding claims, characterized in that said chip (20, 30) is made of silicon.

## Patentansprüche

1. PIN Photodiode mit: einem P-dotierten Halbleiterbereich, einem N-dotierten Halbleiterbereich, einem zwischen diesen P- und N-Bereichen liegenden und diesen Bereichen benachbarten, eigenleitenden Halbleiterbereich I, dessen Transversaldimension, d.h. die senkrecht zur Längsrichtung verlaufende und durch die aufeinanderfolgenden P-, I- und N-Bereiche definierte Dimension, groß genug ist, um ein erhöhtes Ansprechen in einem weiten Wellenlängen-Bereich auf eine in Richtung dieser Dimension angelegte Lichtenergie hervorzurufen, einer sich mit diesem P-Bereich in Kontakt befindlichen Anodenelektrode (22), und einer sich mit diesem N-Bereich in Kontakt befindlichen Kathodenelektrode (23), dadurch gekennzeichnet daß die Dicke des I-Bereichs in der Längsrichtung wesentlich geringer ist als die der P- und N-Bereiche, und daß die Transversaldimension groß genug ist, um die längste gewünschte Lichtwellenlänge zu absorbieren.

2. PIN Photodiode gemäß Anspruch 1, dadurch gekennzeichnet, daß Mittel zur Aufnahme der Erregerlichtenergie in der Transversalrichtung direkt am Rande des I-Bereichs vorgesehen sind.

3. PIN Photodiode gemäß Anspruch 2, dadurch gekennzeichnet, daß diese Mittel zur Aufnahme der Lichtenergie aus wenigstens einer mit einer Lichtenergiequelle verbundenen Lichtfaser (21, 35) bestehen.

4. PIN Photodiode gemäß einem der obigen Ansprüche, dadurch gekennzeichnet daß: die P-, I- und N-Bereiche auf demselben Halbleiterchip (20, 30) hergestellt sind, und daß dieses Chip (20, 30) einem Substrat (24, 31) getragen wird.

5. PIN Photodiode gemäß einem der obigen Ansprüche, dadurch gekennzeichnet, daß das Chip (20, 30) aus Silizium besteht.

# FIG. 1

LUMIERE

# FIG. 2

REPONSE
(AMPERES
/WATT)

1,0
0,8
0,6
0,4
0,2
0,1

BORD

INTERIEUR

0,3  0,4  0,5  0,6  0,7  0,8  0,9  1

LONGUEUR D'ONDES (MICRONS)

FIG. 3

EFFICACITE
(ELECTRONS PAR
PHOTON INCIDENT)

EPAISSEURS
COUCHE AP-
PAUVRIE (mm)

LONGUEUR D'ONDES (MICRONS)

FIG. 4

TEMPS DE TRANSIT
DES ELECTRONS
(NANOSECONDES)

TENSION DIODE

EPAISSEURS
COUCHE APPAUVRIE
(mm)

2

# FIG. 5

# FIG. 6

# FIG. 7